Europäisches Patentamt

European Patent Office

Office européen des brevets

(11) Veröffentlichungsnummer: **0 208 012 B1**

# (12) EUROPÄISCHE PATENTSCHRIFT

(45) Veröffentlichungstag der Patentschrift: **25.09.91**

(51) Int. Cl.5: **H05K 3/42, H01L 21/31**

(21) Anmeldenummer: **85108695.9**

(22) Anmeldetag: **12.07.85**

(54) **Verfahren zum Herstellen von verschmierungsfreien Bohrungen.**

(43) Veröffentlichungstag der Anmeldung:
**14.01.87 Patentblatt 87/03**

(45) Bekanntmachung des Hinweises auf die
Patenterteilung:
**25.09.91 Patentblatt 91/39**

(84) Benannte Vertragsstaaten:
**DE FR GB IT**

(56) Entgegenhaltungen:
**WO-A-80/02353**
**US-A- 4 012 307**

**GALVANOTECHNIK, Band 74, Nr. 10, Oktober
1983, Seiten 1265-1267,Salgau, DE; B. KEGEL:
"Die Optimierung der Prozessparameter
bem Plasma-Ätzen von Leiterplatten"**

**EXTENDED ABSTRACTS, Band 84, Nr. 2,
1984, Seite 522, Abstract Nr. 370, New Orleans, US; N.H. LU et al.: "Epoxy etch rate and
activation energy in CF4/02 plasma"**

(73) Patentinhaber: **IBM DEUTSCHLAND GMBH
Pascalstrasse 100
W-7000 Stuttgart 80(DE)**

(84) Benannte Vertragsstaaten:
**DE**

Patentinhaber: **International Business Machines Corporation
Old Orchard Road
Armonk, N.Y. 10504(US)**

(84) Benannte Vertragsstaaten:
**FR GB IT**

(72) Erfinder: **Ruh, Wolf-Dieter
Sommerhofenstrasse 152/1
W-7032 Sindelfingen(DE)**
Erfinder: **Schäfer, Rolf, Dr.
Ritterstrasse 25
W-7031 Gärtringen-Rohrau(DE)**

(74) Vertreter: **Kreidler, Eva-Maria, Dr.rer. nat.,
Dipl.-Chem.
Schönaicher Strasse 220
W-7030 Böblingen(DE)**

## Beschreibung

Die Erfindung bezieht sich auf ein Verfahren zum Entfernen von Polymerrückständen aus Bohrungen in einer Leiterplatte mit hohem Verhältnis von Bohrlochdurchmesser zu Leiterplattendicke mit einem $CF_4/O_2$ Plasma.

Mehrlagige gedruckte Schaltungen oder Leiterplatten bestehen im allgemeinen aus einer Anzahl von Ebenen aus Kupferleiterzugmustern, welche voneinander durch Isolierschichten getrennt sind. In der heutigen Leiterplattentechnologie enthalten Leiterplatten, welche z.B. Abmessungen von 700 mm x 600 mm und eine Dicke bis zu 4,6 mm aufweisen können, bis zu 22 durch glasfaserverstärkte Epoxidharzschichten getrennte Stromversorgungs- und Signalebenen. Ihre Herstellung erfolgt, indem man auf eine sogenannte Grundbaugruppe aus einigen Lagen Prepreg beidseitig Kupferfolien auflaminiert und in diesen in einem subtraktiven Photoätzprozeß eine Schaltung herstellt. Dann werden beidseitig einige Lagen Prepreg und darauf jeweils eine Kupferfolie auflaminiert. In einem Photoätzprozeß und durch semi-additives Verkupfern werden Signalleitungen aufgebracht. In einem nächsten Schritt werden beidseitig weitere Isolierstoffebenen und eine Kupferfolie aufgebracht, und es wird eine Schablone für das Bohren von Löchern hergestellt. Mit einem Laserstrahl werden zur Verbindung der beiden Signalebenen Löcher gebohrt und anschließend in einem Photoätzprozeß und durch semi-additives Verkupfern beidseitig Signalleitungen aufgebracht, wobei die gebohrten Löcher mitverkupfert werden. Schließlich werden in einem Laminiervorgang mehrere solcher Komponenten sowie Kupferfolien auf den beiden äußeren Oberflächen zusammenlaminiert. Zum Verbinden der einzelnen Lagen untereinander werden dann durch die Leiterplatten hindurchgehende Löcher gebohrt. Bei Leiterplatten mit den oben angegebenen Abmessungen müssen etwa 40 000 Löcher mit einem Durchmesser von etwa 0,4 mm gebohrt werden. Bei diesem Bohren besteht die Gefahr, daß das Bohrmehl von der Bohrernebenschneide gegen die Bohrungswand gedrückt und dort zu einem festen Film angerieben wird. Diese Verunreinigungen sind nur sehr schwer zu entfernen und führen zu unsauberen Kontaktierungen der einzelnen Innenlagen untereinander.

Man hat daher schon vorgeschlagen (DE-OS 17 04 296), zur raschen Abfuhr des Bohrmehls einen Druckluftstrahl zu verwenden, mittels dem das Bohrmehl während des Bohrens oder nach erfolgtem Bohren aus den Kontaktierungslöchern herausgeblasen werden soll. Diese Verfahrensweise führt jedoch nicht zu dem gewünschten Erfolg. In der deutschen Patentschrift 26 06 984 ist ein Verfahren zum chemischen Reinigen von Kontaktierungslöchern in Mehrlagen-Leiterplatten mit Hilfe einer aggressiven, Epoxidharzverschmierungen in der Lochwand lösenden Säure als Reinigungsmedium und eine Einrichtung zur Durchführung dieses Verfahrens beschrieben. Nach diesem Verfahren wird die Leiterplatte nach dem Bohren der Kontaktierungslöcher mit konstanter Geschwindigkeit in einer abgeschlossenen Kammer horizontal über eine Schwallstrecke hinweggeführt, die von einem unterhalb der Transportbahn und senkrecht zur Transportrichtung angeordneten Schlitzrohr gebildet wird, aus dem konzentrierte Schwefelsäure unter Druck austritt, welche die Kontaktierungsbohrungen der Leiterplatte intensiv durchspült. Anschließend wird die Leiterplatte unter einem scharfen Luftstrahl abgeblasen und gespült. Nachteilig an diesem Verfahren ist, daß zur Entfernung der Verschmierungen aus den Bohrlöchern korrodierende Chemikalien verwendet werden müssen, die für die Umwelt eine Belastung darstellen. Entsprechendes gilt für das in der US-Patentschrift 4 155 775 beschriebene Verfahren zur Reinigung von Löchern in mehrlagigen Leiterplatten, welche ein hohes Verhältnis von Lochdurchmesser zu Leiterplattendicke aufweisen. Bei diesem Verfahren ist der Reinigung der Oberflächen der Löcher mit Chromschwefelsäure eine Reinigung mittels Sandstrahlen und eine Entfernung der losen Fasern mit einem geeigneten Lösungsmittel vorgeschaltet.

In der US-Patentschrift 4 012 307 wird eine Plasmabehandlung zur Reinigung von Bohrlöchern in Leiterplatten beschrieben, bei der niedrige Drucke und niedrige Temperaturen und als Gase Sauerstoff oder eine Mischung von Sauerstoff und Kohlenstofftetrafluorid angewendet werden. Dieses Verfahren soll allen Naßreinigungsverfahren überlegen sein. Es wurde jedoch festgestellt, daß in dem beschriebenen System eine nur teilweise Reinigung der Bohrlöcher stattfindet, weil das Plasma unvollständig in die Bohrlöcher eindringt. Eine gewisse Verbesserung wurde erzielt durch den Übergang von einem Reaktor mit Ringelektroden zu einem solchen mit einer Parallelplatten-Elektrodenkonfiguration. In einer weiteren Verbesserung (PCT-Anmeldung WO 80/02353) wurden die Kupferoberflächen der gebohrten Leiterplatten selbst als Elektroden verwendet, welche das Plasma erzeugen und dessen Form in der Umgebung der zu reinigenden Bohrlöcher bestimmen. Außerdem wurden zur Verbesserung der Gleichförmigkeit der Epoxidätzung über die Oberfläche einer Leiterplatte hinweg auf die vier Kanten der Leiterplatte dielektrische Feldabschwächer aus einem Polymermaterial aufgesetzt. Nachteilig an dem Verfahren ist, daß bei einem Kurzschluß in der Oberfläche einer Leiterplatte überhaupt kein Plasma erzeugt wird. Deshalb hat dieser Reaktortyp keinen Eingang in die Leiterplattenherstellung gefunden.

In den letzten Jahren wurden viele naßchemische Ätz-prozesse durch Trockenprozesse, beispielsweise

EP 0 208 012 B1

durch Gasplasmaätzprozesse, ersetzt. Bei diesen Prozessen werden Moleküle im Plasma ionisiert, viele andere brechen auseinander und bilden freie Radikale, d.h. es entstehen Molekülfragmente, welche ungepaarte, nicht an Bindungen beteiligte Elektronen enthalten. Durch die Gegenwart von Ionen und insbesondere von freien Radikalen wird das Plasma extrem reaktiv. Typische Anwendungen schließen das Ätzen von Kunststoffoberflächen ein, welches bei niedriger Temperatur und niedrigem Druck durchgeführt werden kann. Die Apparaturen zur Erzeugung und Anwendung von Plasmen bei niedriger Temperatur und niedrigem Druck sind relativ einfach und vermeiden viele Nachteile, die bei naßchemischen Prozessen auftreten. Die Plasmareaktionsprodukte sind beispielsweise gasförmig, so daß keine festen Rückstände nach dem Plasmaätzprozeß zurückbleiben. Typische Gase, welche beim Plasmaätzen Anwendung finden sind Sauerstoff ($O_2$) oder eine Mischung von Sauerstoff und Kohlenstofftetrafluorid ($CF_4$), wobei das Kohlenstofftetrafluorid als Quelle für atomares Fluor dient.

In der Elektronikindustrie wurden Plasmaätzprozesse zum flächenhaften Ätzen von Kunststoffoberflächen eingesetzt. In der US-Patentschrift 3 806 365 ist beispielsweise die Entfernung von Photoresistmaterialien von Halbleiteroberflächen durch ein Plasma aus Sauerstoff und Organohalogenverbindungen beschrieben. In den US-Patentschriften 3 816 196 und 3 816 198 ist die Verwendung eines Sauerstoffplasmas zum Ätzen von Mustern in Kunststofffilme durch eine Photoresistmaske bei der Halbleiterfertigung beschrieben. In der US-Patentschrift 3 615 956 ist die Verwendung eines Sauerstoff- und Kohlenstofftetrafluoridplasmas zum Polieren und Reinigen von Halbleiterwafern beschrieben.

In der zuvor bereits erwähnten US-Patentschrift 4 012 307 wird ein Plasmaätzverfahren zum Reinigen von in Leiterplatten gebohrten Löchern von Verschmierungen beschrieben. Hierzu wird eine Gasmischung aus Sauerstoff und Kohlenstofftetrafluorid verwendet. Es besteht in der Literatur Einigkeit darüber, daß Mischungen mit einem Gehalt an etwa 15 bis 30 Vol.% $CF_4$ und bei einem Druck von etwa 0,267 mbar zu den am schnellsten ätzenden Mischungen für die Entfernung von Epoxidharzverschmierungen aus Löchern in Leiterplatten gehören. Deshalb wurden Mischungen mit einem Gehalt an 30 Vol.% Kohlenstofftetrafluorid, Rest Sauerstoff, bisher zum Reinigen von Leiterplatten mit einem Verhältnis des Lochdurchmessers zur Dicke der Leiterplatte von etwa 1:1 bis 1:3 mit Erfolg eingesetzt. Hinsichtlich der Gleichmäßigkeit beim Ätzen traten dagegen Schwierigkeiten auf, wenn die zu reinigenden Leiterplatten sehr groß waren, beispielsweise eine Größe von 600 x 700 mm aufwiesen, und dazu bei den zu reinigenden Leiterplatten ein hohes Verhältnis von Lochdurchmesser zur Dicke der Leiterplatte von etwa 1:11 bis 1:13 vorhanden war.

Es wurde festgestellt, daß die Gleichmäßigkeit der Ätzung, bezogen auf die einzelne Leiterplatte und die Gleichmäßigkeit von Leiterplatte zu Leiterplatte bei Beladung eines Parallelplattenreaktors mit mehreren Leiterplatten mit den oben angegebenen Abmessungen und dem oben angegebenen Verhältnis von Lochdurchmesser zur Dicke der Leiterplatte nicht ausreichend war. Bei Anwendung eines Ätzgases mit einem Gehalt an 30 Vol.% $CF_4$ ist die Ätzgeschwindigkeit an den Eingängen der Bohrlöcher am größten, nimmt aber zur Lochmitte hin ab. Entsprechendes gilt für die einzelne Leiterplatte, bei der die Ätzgeschwindigkeit an Rand der Platte größer ist als im Zentrum.

Aufgabe der Erfindung ist ein Verfahren zum Entfernen von Polymerrückständen aus Bohrungen in einer Leiterplatte. Durch dieses Verfahren wird die Herstellung verschmierungsfreier Bohrungen durch Plasmaätzen mit einem $CF_4$-$O_2$-Gasgemisch ermöglicht, bei dem die $CF_4$-Konzentration so gewählt wird, daß die einzelnen Bohrlöcher mit einem hohen Verhältnis von Lochdurchmesser zur Dicke der Leiterplatte von den Epoxidverschmierungen gereinigt werden können, bei gleichzeitig vorhandener Ätzgleichmäßigkeit durch das einzelne Loch, über die Leiterplatten in den einzelnen Zellen und über den ganzen Zellensatz des Plasmareaktors.

Die Aufgabe der Erfindung wird gelöst durch ein Verfahren gemäß den Patentansprüchen 1 und 2.

Wie nachfolgend beschrieben wird, wurde die Effektivität des Plasmareinigungsverfahrens anhand von Messungen untersucht, um Aussagen hinsichtlich der Entfernung des Epoxidschmierfilms (hohe Ätzrate); der Gleichmäßigkeit der Ätzung, bezogen auf das Innere eines Loches; der Gleichmäßigkeit der Ätzung, bezogen auf die einzelne Leiterplatte und der Gleichmäßigkeit der Ätzung von Leiterplatte zu Leiterplatte machen zu können. Der $CF_4$-Gehalt des Ätzgases wurde zwischen 2 und 80 Vol.% variiert, wobei der Rest jeweils Sauerstoff war. Alle anderen Parameter blieben unverändert. Mit Hilfe von Proben, welche in die Leiterplatten eingesetzt wurden, wurde die Epoxidrückätzung in den Löchern gemessen. Mit den $CF_4$-Gehalten, welche die vorteilhaftesten Epoxidrückätzungen und Gleichmäßigkeiten der Ätzung ergaben, wurden im Hinblick auf die Reproduzierbarkeit weitere Versuchsreihen durchgeführt. Der Einfluß des $CF_4$-Gehalts auf die Leiterplattentemperatur wurde ebenfalls untersucht.

Die Figuren 1 bis 6 stellen im einzelnen dar:

Fig. 1       einen Parallelplattenreaktor mit Belegung der Zellen 2 bis 9 (Elektroden nicht dargestellt);

Fig. 2       eine Leiterplatte mit eingesetzten Proben in den Positionen A und E;

3

Fign. 3A bis 3E    eine Darstellung der Untersuchungsmethode mit eingesetzten Proben;
Fig. 4    Epoxidrückätzung und Ätzgleichmäßigkeit in Zelle 6;
Fig. 5    Epoxidrückätzung und Ätzgleichmäßigkeit in Zelle 8;
Fig. 6    Epoxidrückätzung und Ätzgleichmäßigkeit von Zelle 6 zu Zelle 8.

Alle Versuchsreihen wurden in einem Mehrzellen-Parallelplatten-Plasmareaktor vom Typ 7415 der Firma Branson/IPC Inc., Hayward, CA. mit einem 13,5 MHz-Generator durchgeführt. Die Prozeßparameter und die Prozeßfolge für alle Plasmaversuchsreihen waren bis auf die unterschiedlichen $CF_4$-Gehalte die gleichen:

Gesamtgasfluß:    1,2 1/Min.
Druck:    0,3333 mbar
Ausgangsleistung:    3500 Watt
Beladung:    8 Leiterplatten mit einer Größe von 600 × 700mm.

Um die Leiterplattentemperatur, während der Plasmabehandlung mit Hochfrequenz, unter der Epoxidglasübergangstemperatur von etwa 128°C zu halten, wurde die Reihenfolge:
25 Minuten Plasmabehandlung,
10 Minuten geöffnete Reaktortür zur Abkühlung der Leiterplatten und der Ausrüstung,
25 Minuten Plasmabehandlung
eingehalten.

Der $CF_4$-Gehalt wurde am Gaseinlaß im Bereich von 2 bis 80 Vol.% variiert. Hohe und niedrige $CF_4$-Gehalte wurden alternativ angewendet, damit Systemfehler, welche auf den Wechsel der Leiterplatten, Unzuverlässigkeiten der Ausrüstung oder Prozeßinstabilitäten zurückzuführen waren, ausgeschaltet werden konnten:

## TABELLE 1

| $CF_4$-Gehalt Vol. % | $CF_4$-Fluß 1/Min. | Reihe Nr. |
|---|---|---|
| 2 | 0.024 | 11 |
| 10 | 0.120 | 6 |
| 20 | 0.240 | 9 |
| 30 | 0.360 | 7 |
| 40 | 0.480 | 5 |
| 50 | 0.600 | 3 |
| 60 | 0.720 | 1 |
| 70 | 0.840 | 2 |
| 80 | 0.960 | 4 |

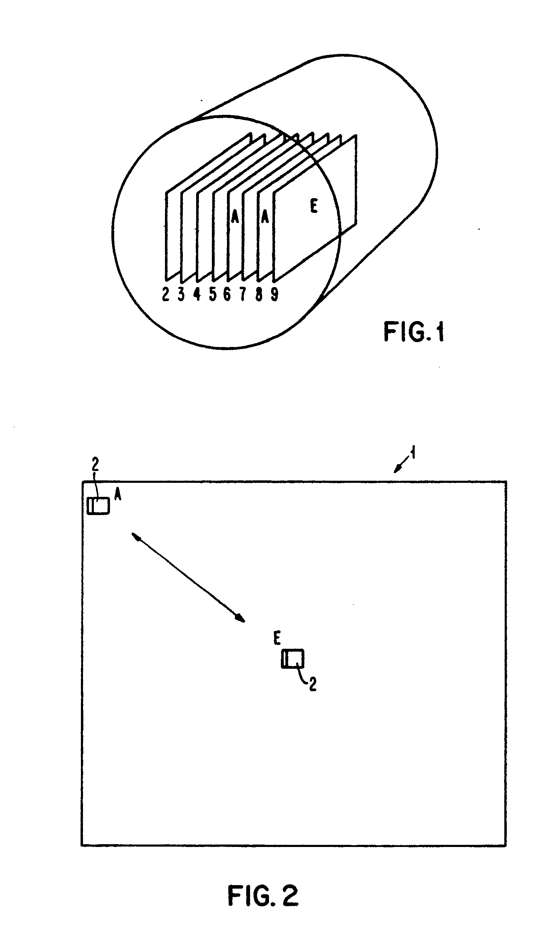

Wegen der niedrigen Epoxidrückätzung in den beiden äußeren Zellen des Parallelplattenreaktors, welcher normalerweise mit 10 Leiterplatten beladen werden kann, wurden zum Ätzen nur die 8 inneren Zellen mit Leiterplatten beladen. Um die Gleichmäßigkeit der Ätzung über alle 8 mit Leiterplatten beladenen Zellen des Reaktors zu bestimmen, wurde die Epoxidrückätzung auf der Leiterplatte in der Zelle mit der höchsten Rückätzung, d.h. in Zelle 6, und auf der Leiterplatte in der Zelle mit der niedrigsten Rückätzung, d.h. in Zelle 8, bestimmt. Daß in Zelle 6 die höchste Rückätzung der Epoxidharzverschmierung stattfindet, ist wahrscheinlich auf unsymmetrische Zuführung der elektrischen Leistung in die Elektrodenpaare und auf eine entsprechende Temperaturverteilung im Reaktor zurückzuführen. Außerdem könnte die Gasflußführung eine Rolle spielen. Bei allen Versuchsreihen wurden die Leiterplatten elektrisch freihängend zwischen den Platten des Parallelplattenreaktors angeordnet. In Fig. 1 ist ein Reaktor, welcher in den Zellen 2 bis 9 beladen ist, dargestellt, wobei die Elektroden nicht eingezeichnet sind.

Die Ätzgleichmäßigkeit über die Zellen 2 bis 9 wurde bestimmt, indem die Epoxidrückätzung in den Löchern der Leiterplatten in den Zellen 6 und 8 an der am höchsten ätzenden Stelle (mit A bezeichnet) an der Außenseite der Leiterplatten und an der am niedrigsten ätzenden Stelle (mit E bezeichnet) in der Mitte der Leiterplatten bestimmt wurde. Besagte Zellen wurden mit präparierten Leiterplatten 1 beladen, in welche an den Stellen A und E Proben 2 eingesetzt waren (Fig. 2). Der Rest der Zellen wurde mit nichtpräparierten Leiterplatten beladen.

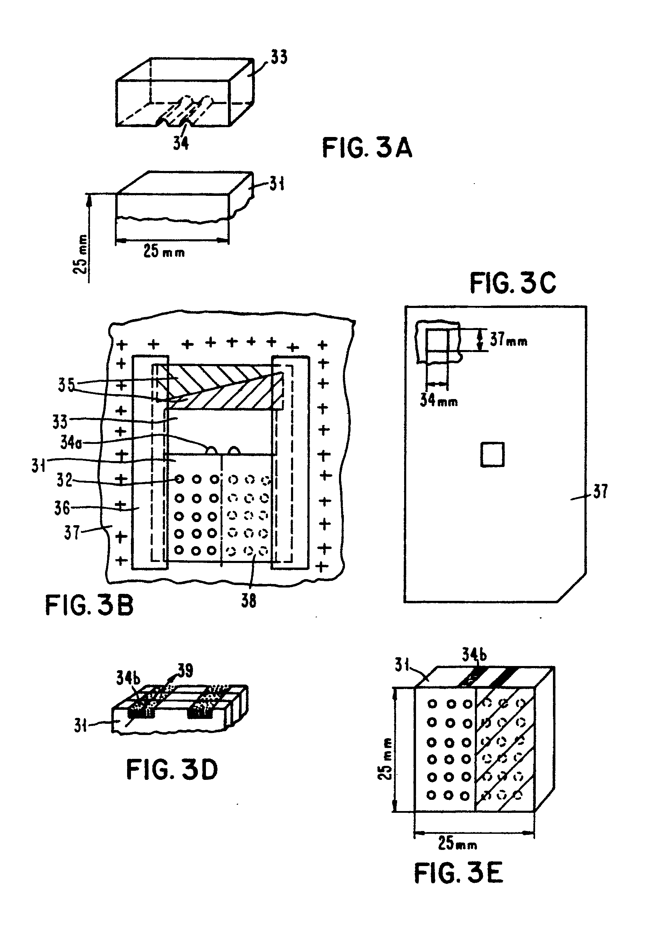

Die Untersuchung der Ätzgleichmäßigkeit über die Leiterplatten mit Hilfe der eingesetzten Proben wird anhand der Fign. 3A bis 3E beschrieben (vgl. auch IBM-TDB Vol. 25, Nr. 1, Juni 1982, S. 284-285, W. D. Ruh, Test Specimen for Plasma Etch Process). Für die Untersuchungen werden Proben 31 mit Abmessungen von 25 mm × 25 mm aus gebohrten Leiterplatten und Masken 33 mit Abmessungen von 10 mm × 25 mm geschnitten. Die Proben 31 enthalten deshalb gebohrte Durchgangslöcher 32. Je eine Schnittfläche der Probe und der Maske wird poliert, damit beide exakt aufeinanderliegen. Die polierte Oberfläche der Maske 33 ist mit Schlitzen 34 versehen, um Durchgangslöcher (34a) zu simulieren (Fig. 3B), wenn die Probe 31 und die Maske 33 mit ihren polierten Oberflächen zusammengesetzt sind. Beim Ätzen durch die Masken werden in der Probe Vertiefungen 34b von etwa der gleichen Breite wie der Durchmesser der gebohrten Durchgangslöcher gebildet. Die Masken-Probenpaare werden zum Ätzen in die Fenster einer Leiterplatte 37 gemäß Fig. 3C eingesetzt. Sie werden in dieselbe, wie in Fig. 3B in Vergrößerung dargestellt ist, mittels Keilen 35 eingespannt und aufeinandergepreßt. Jedes Proben-Maskenpaar ist beidseitig mit einer Kupferabdeckung 36 versehen. Die Hälfte der in der Probe 31 enthaltenen Durchgangslöcher 32 ist während des Ätzens mit einer Aluminiumfolie 38 abgedeckt. Während des Plasmaätzens wird das Epoxidharz der Probe 31 an der polierten Oberfläche im Bereich der simulierten Durchgangsöffnungen 34a durch die reaktiven Spezies geätzt, und es werden in der Probe Vertiefungen 34b gebildet, ohne daß gleichzeitig die Glasfasern und die Kupferebenen in nennenswerter Weise angeätzt werden. An den geätzten Proben kann die Epoxidrückätzung mit Hilfe eines Oberfächenanalysators bestimmt werden, wobei die Abtastspur 39 des Griffels in der aus Fig. 3D ersichtlichen Richtung verläuft. Aus den Abtastspuren der Epoxidrückätzung können die Ätzgeschwindigkeiten und die Gleichmäßigkeit der Ätzung entlang der geätzten Vertiefungen 34b berechnet werden.

Gleichzeitig können an den Proben mit ihren gebohrten Durchgangslöchern 32 plasmagereinigte mit nicht gereinigten Löchern anhand von Quer- und Flachschnitten nach der Kupferplattierung der Durchgangslöcher verglichen werden. Zu diesem Zweck wurde, wie zuvor bereits angegeben, die Hälfte der in die Probe 31 gebohrten Durchgangslöcher 32 beidseitig mit selbstklebender Aluminiumfolie 38 bedeckt, um die Einwirkung des Plasmas während des Verfahrens zu verhindern (Fign. 3B und 3E). Ein Vorteil der Untersuchungsmethode anhand der Querschnitte ist, daß sie direkt an der prozessierten Leiterplatte durchgeführt werden kann, um die Produktqualität auszuwerten. Nachteilig an dieser Methode ist aber, daß die Auflösung gering ist, weil der niedrigste erfaßbare Wert der Epoxidrückätzung an der Glasfaser nur bei etwa 3 $\mu$m liegt, was auf die niedrige, 250-fache Vergrößerung mit dem Mikroskop und auf die aufgerauhte Struktur der Bohrlochwandungen zurückzuführen ist. Im Gegensatz hierzu weist die zuvor beschriebene Methode zur Bestimmung der Epoxidrückätzung anhand der eingesetzten Proben eine Auflösung von etwa 0,2 $\mu$m auf, was auf die polierte Oberfläche der Probe und die hohe Auflösung des mechanischen Oberflächenanalysators (etwa 5000-fach) zurückzuführen ist. Diese hohe Auflösung gestattet die sehr genaue Erstellung eines Rückätzungsprofiles entlang der Vertiefungen 34b, wobei die Oberflächen der Kupferzwischenebenen und der Glasfasern als Referenzlinien für die Messung des Epoxidrückätzungsprofiles mit dem Oberflächenanalysator dienen. Mit dieser Methode wurde das Epoxidrückätzungsprofil in den Vertiefungen 34a an den Stellen A und E der Leiterplatten in der Zelle 6 und der Zelle 8 bestimmt. Es wurde die Ätzgleichmäßigkeit über die Zellen 6 und 8 und über den ganzen Zellensatz, d.h. die Platten 2 bis 9 ermittelt.

Die Leiterplattentemperatur während des Plasmaätzens wurde in beiden Zellen an den Leiterplatten in der Nachbarschaft der vier eingesetzten Proben gemessen. Es traten Temperaturen von etwa 74 bis 121$^\circ$ C auf, welche in Schritten von 5 bis 6$^\circ$ C erfaßt wurden. Selbstklebende Aluminiumfolien bedeckten die Streifen, die zur Messung der Temperatur verwendet wurden, um sie vor dem Plasma zu schützen.

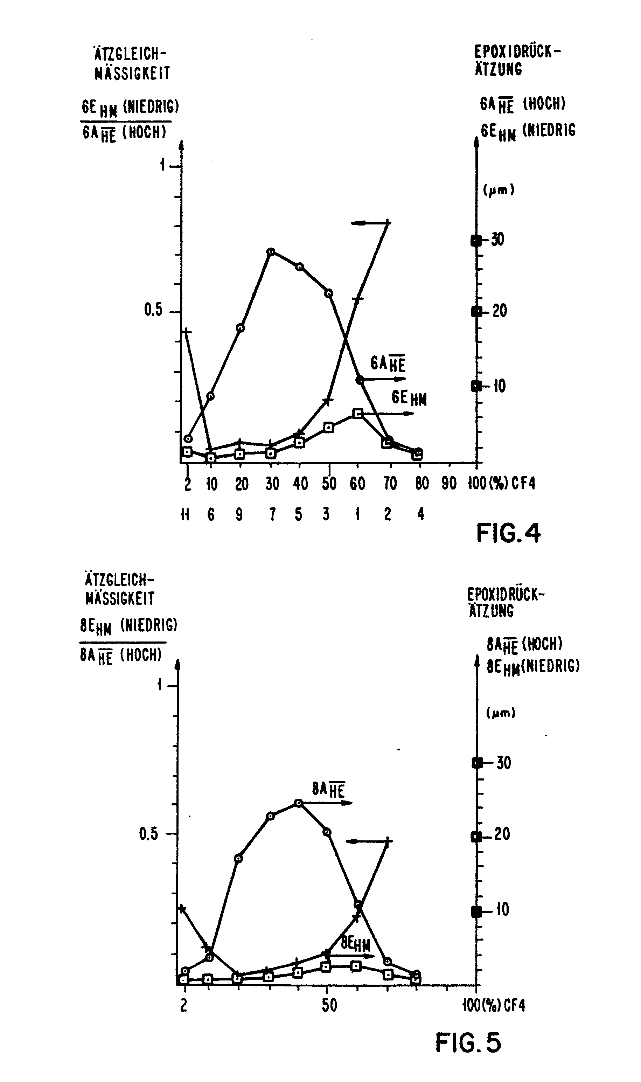

Anhand der Fign. 4 bis 6 werden nachfolgend die Ergebnisse der Messungen diskutiert. Wie bereits zuvor angegeben, wird die höchste Epoxidrückätzung immer an den Locheingängen in den Außenbereichen der Leiterplatte in der Position A (Fig. 2) erhalten, die niedrigste dagegen in der Lochmitte von Löchern in der Position E in der Leiterplattenmitte. So werden beispielsweise mit einer Mischung aus 20 Vol.% $CF_4$, Rest Sauerstoff, an den Locheingängen der Leiterplatte in Zelle 6 in der Position A Epoxidrückhtzungen $6A_{HE}$ von 18,9 $\mu$m und 17,1 $\mu$m, d.h. ein Mittelwert $6A_{HE}$ von 18,0 $\mu$m, erhalten. Als niedrigster Wert für die Rückätzung wird bei Anwendung derselben Gasmischung in der Zelle 6 in der Lochmitte der Leiterplatte in der Position E ein Wert $6E_{HM}$ von 1,1 $\mu$m erhalten.

In den Fign. 4 und 5 sind für die Zellen 6 und 8 des Plasmareaktors die Werte für die Epoxidrückätzung als Mittelwert aus den an den beiden Locheingängen in der Position A gemessenen Werten, $6A_{HE}$ und $8A_{HE}$ und die Werte für die Epoxidrückätzung in der Lochmitte in der Position E, $6E_{HM}$ und $8E_{HM}$ und die entsprechende Ätzgleichmäßigkeit über die Leiterplatte

$$\frac{6E_{HM}}{6A_{\overline{HE}}} \quad\text{bzw.}\quad \frac{8E_{HM}}{8A_{\overline{HE}}}$$

jeweils gegen den $CF_4$-Gehalt des Ätzgases (von 2 bis 80 vol.%), Rest Sauerstoff, aufgetragen. In Fig. 4 ist außerdem unter dem $CF_4$-Gehalt die Reihenfolge angegeben, in der die Messungen mit den einzelnen $CF_4$-Konzentrationen durchgeführt wurden.

Die Ätzgleichmäßigkeit über eine Zelle, d.h. über eine Leiterplatte als Funktion des $CF_4$-Gehalts ist in hohem Maße abhängig von der Epoxidrückätzung an den Locheingängen (Position A). In der am schnellsten ätzenden Zelle 6 (Fig. 4) nimmt die Epoxidrückätzung an den Locheingängen $6A_{HE}$ bei steigendem Gehalt des Ätzgases an $CF_4$ bis etwa 30 Vol.% stark zu, um dann wieder abzufallen:

| % $CF_4$ | 2 | 10 | 20 | 30 | 40 | 50 | 60 | 70 | 80 |
|---|---|---|---|---|---|---|---|---|---|
| $6A_{\overline{HE}}$ (µm) | 3,6 | 9,0 | 18,0 | 28,3 | 26,5 | 22,8 | 10,7 | 3,0 | 1,4 |

Die Epoxidrückätzung in der Lochmitte (Position E) nimmt mit steigendem Gehalt an $CF_4$ zwar auch, aber wesentlich langsamer zu:

| % $CF_4$ | 2 | 10 | 20 | 30 | 40 | 50 | 60 | 70 | 80 |
|---|---|---|---|---|---|---|---|---|---|
| $6E_{HM}$ | 1,6 | 0,4 | 1,1 | 1,4 | 2,6 | 4,7 | 6,1 | 2,5 | 1,3 |

Sie erreicht ihren höchsten Wert bei einem $CF_4$-Gehalt des Ätzgases von etwa 60 Vol.%.

Die Ätzgleichmäßigkeit über die Leiterplatte errechnet sich, indem man den Wert für die Rückätzung in der Lochmitte durch den Mittelwert für die Rückätzung an den Locheingängen dividiert:

| % $CF_4$ | 2 | 10 | 20 | 30 | 40 | 50 | 60 | 70 | 80 |
|---|---|---|---|---|---|---|---|---|---|
| $\dfrac{6E_{HM}}{6A_{\overline{HE}}}$ | 0,44 | 0,044 | 0,061 | 0,049 | 0,0098 | 0,206 | 0,57 | 0,83 | 0,92 |

Aus diesen Werten ist ersichtlich, daß bei $CF_4$-Konzentrationen unter etwa 10 Vol.% die Ätztzgleichmäßigkeit in der Zelle sehr hoch ist. Da wenig Fluor im Ätzgas vorhanden ist und Sauerstoff die ätzenden Spezies liefert, findet kaum eine beschleunigte Ätzung an den Locheingängen statt. Die höchste Rückätzung in der Lochmitte findet bei 60 Vol.% $CF_4$ statt, während bei diesem $CF_4$-Gehalt die Rückätzung an den Locheingängen infolge Passivierung bereits stark zurückgegangen ist. Es wird deshalb bei dieser $CF_4$-Konzentration eine hohe Ätzgleichmäßigkeit von 0,57 erhalten. Bei Übergang zu noch höheren $CF_4$-Gehalten steigt die Ätzgleichmäßigkeit weiter an, allerdings nimmt die Rückätzung gleichzeitig ab.

In Zelle 8, der am langsamsten ätzenden Zelle des Plasmareaktors, nimmt die Epoxidrückätzung mit steigendem $CF_4$-Gehalt des Ätzgases auch zu, aber ingesamt wesentlich langsamer als in Zelle 6. Das Maximum für die Rückätzung an den Locheingängen $8A_{HE}$ von 24 µm (Fig. 5) wird erst bei einem $CF_4$-Gehalt von 40 Vol.% (in Zelle 6 bei 30 Vol.%) erreicht. In der Lochmitte wird das Maximum für die Rückätzung $8E_{HM}$ von 2,5 µm, wie in Zelle 6, auch bei 60 Vol.% $CF_4$ erreicht. Die Werte für die Ätzgleichmäßigkeit bei 40 bzw. 60 Vol.% CF$_4$ in Zelle 8 betragen 0,0735 und 0,231. Daß die Epoxidrückätzung in Zelle 8 insgesamt niedriger ist als in Zelle 6, ist möglicherweise auf unterschiedliche Leiterplattentemperaturen während des Plasmaätzens zurückzuführen. Es wurde nämlich festgestellt, daß die Leiterplattentemperatur in Zelle 8 immer niedriger ist als in Zelle 6. Die Leiterplattentemperatur nimmt in jeder Zelle mit steigendem CF$_4$-Gehalt des Ätzgases zu, erreicht in Zelle 6 bei 50 bis 60 Vol.% CF$_4$ ein Maximum von etwa 121° C und in Zelle 8 bei 60 Vol.% CF$_4$ ein Maximum von etwa 108° C.

Der Kurvenverlauf für die Epoxidrückätzung läßt sich durch einen zum Ätzen von Polymermaterialien mit dem Plasmasystem O$_2$/CF$_4$ vorgeschlagenen Mechanismus erklären. Nach diesem Mechanismus nimmt zunächst mit zunehmender CF$_4$-Konzentration die relative Konzentration an Fluoratomen an der Epoxidoberfläche zu. Die Fluoratome reagieren mit dem Epoxid und brechen bestehende Bindungen auf unter Ausbildung aktiver Zentren für den Angriff des Ätzmediums. Bei höheren CF$_4$-Konzentrationen dagegen bilden sich an der Epoxidoberfläche vorwiegend CF$_x$-Bindungen, die eine Oberflächenpassivierung bewirken und zu einer Abnahme der Epoxidrückätzung führen. Diese Erkenntnisse lassen sich auf die Reinigung von Bohrlöchern mit einem hohen Verhältnis von Lochdurchmesser zur Dicke der Leiterplatte anwenden. Dort findet mit steigendem CF$_4$-Gehalt des Ätzgases eine starke Rückätzung des Epoxids an den Locheingängen unter Verbrauch allen verfügbaren Fluors statt. Durch die gleichzeitig auftretende Verarmung an aktivem Fluor findet eine niedrigere Rückätzung des Epoxids in der Mitte der Bohrlöcher statt. Die bei höheren CF$_4$-Gehalten auftretende Oberflächenpassivierung erklärt den Rückgang der Ätzung an den Locheingängen und die Zunahme der Ätzung in der Lochmitte aufgrund des dort wieder reichlicher vorhandenen aktiven Fluors. Bei noch weiter ansteigendem CF$_4$-Gehalt findet auch in der Lochmitte eine Oberflächenpassivierung statt, so daß sich die Rückätzungen in der Lochmitte und an den Locheingängen in etwa die Waage halten und die Ätzgleichmäßigkeit über die Zelle zunimmt. In Zelle 6 wird z.B. bei einem CF$_4$-Gehalt von 60 Vol.% eine Zellengleichmäßigkeit von 0,57 erhalten. Mit 70 Vol.% CF$_4$-Gehalt wird aufgrund der Oberflächenpassivierung auch in der Lochmitte eine Gleichmäßigkeit über die Zelle von 0,83 erhalten.

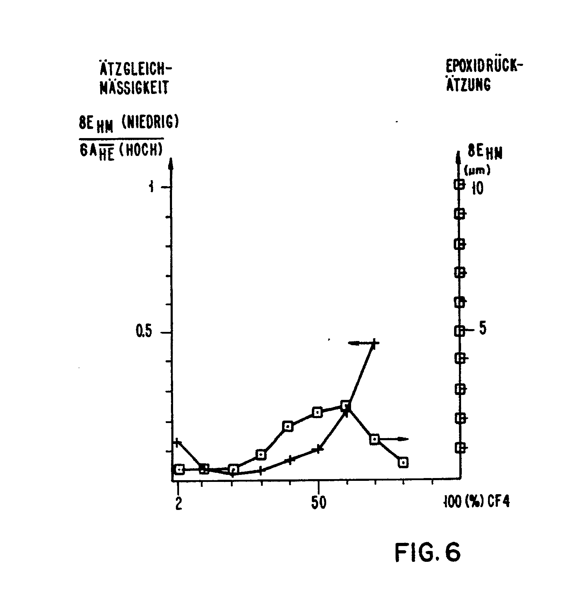

In Fig. 6 ist die Ätzgleichmäßigkeit über den Plasmareaktor von Zelle 6 zu Zelle 8 und die Stelle der niedrigsten Rückätzung in beiden Zellen, d.h. die Rückätzung in der Bohrlochmitte in der Leiterplattenmitte von Zelle 8 (Position E), in Abhängigkeit von der CF$_4$-Konzentration, dargestellt. Die Gesamtätzgleichmäßigkeit errechnet sich, indem man die Werte für die Rückätzung in der Bohrlochmitte von Zelle 8 8E$_{HM}$ durch die Werte für die Rückätzung an den Locheingängen von Zelle 6 6A$_{HE}$ dividiert. Mit 70 Vol.% CF$_4$ wird eine Ätzgleichmäßigkeit von 0,48, allerdings bei niedriger Epoxidrückätzungsrate, erhalten.

Tabelle 2 zeigt alle Ätzgleichmäßigkeiten, die bei Anwendung eines Gasgemisches aus 60 Vol.% CF$_4$, Rest Sauerstoff, erhalten werden:

# EP 0 208 012 B1

## TABELLE 2

### $\bar{X}$ Epoxidrückätzung

Gleichmäßigkeit

| Zelle | | 6 | | | 8 | | | 6 zu 8 |
|---|---|---|---|---|---|---|---|---|
| Leiterplattenposition | | A | E | E/A | A | E | E/A | E/A |
| Gleichmäßigkeit des Lochs: | $\dfrac{HM}{HE}$ | .798 | .626 | | .793 | .403 | | |
| Gleichmäßigkeit der Zelle: | $\dfrac{E_{HM}}{A_{HE}}$ | | | .555 | | | .200 | |
| Gleichmäßigkeit des Reaktors: | $\dfrac{\text{Zelle }8E_{MH}}{\text{Zelle }6H_{HE}}$ | | | | | | | .199 |

Zusammenfassend kann gesagt werden, daß der Einfluß des $CF_4$-Gehalts auf die Epoxidrückätzung und die Ätzgleichmäßigkeit von Bohrlöchern in Leiterplatten mit hohem Verhältnis von Lochdurchmesser zur Dicke der Leiterplatte von etwa 1:11 bis 1:13 in einem Branson 7415 mehrzelligen Parallelplattenreaktor anhand eingesetzter Proben untersucht werden konnte. Der Plasmareinigungsprozeß mit 60 Vol.% $CF_4$, Rest Sauerstoff, ergab im Hinblick auf einen Mittelwert der Epoxidrückätzung, auf die Gleichmäßigkeit innerhalb der Bohrlöcher, die Gleichmäßigkeit über die einzelne Leiterplatte und die Gleichmäßigkeit über den gesamten Plasmareaktor die besten Ergebnisse. Bei einem $CF_4$-Gehalt von etwa 10 Vol.% und darunter wurde zwar auch eine verbesserte Ätzgleichmäßigkeit beobachtet, allerdings war bei dieser $CF_4$-Konzentration die Epoxidrückätzung wesentlich niedriger als bei 60 Vol.% $CF_4$.

Anhand der eingesetzten Proben konnte auch festgestellt werden, daß der $CF_4$-Gehalt des Ätzgases die Ätzfront durch das Bohrloch hindurch bestimmt, so daß, je nach $CF_4$-Gehalt, im Querschnitt konkave, gerade oder konvexe Bohrwände hergestellt werden können.

## Patentansprüche

1. Verfahren zum Entfernen von Polymerrückständen aus Bohrungen in einer Leiterplatte mit hohem Verhältnis von Bohrlochdurchmesser zu Leiterplattendicke mit einem $CF_4/O_2$-Plasma,

dadurch gekennzeichnet,

daß die Rückätzung von Polymerrückständen in den Locheingängen $A_{HE}$ an der am höchsten ätzenden Stelle A in den Außenbereichen einer Leiterplatte und die Rückätzung derselben in der Lochmitte $E_{HM}$ an der am niedrigsten ätzenden Stelle E in der Mitte derselben Leiterplatte bestimmt werden;

der Mittelwert aus den in den beiden Locheingängen an der Stelle A gemessenen Werten $A_{HE}$ gebildet wird;

die Gleichmäßigkeit der Ätzung über die Leiterplatte ermittelt wird, indem man den Wert für die Rückätzung in der Lochmitte $E_{HM}$ an der Stelle E durch den Mittelwert für die Rückätzung in den Locheingängen $A_{HE}$ an der Stelle A dividiert, und der so bestimmte Quotient dazu benutzt wird, den für

8

die Gleichmäßigkeit der Ätzung optimalen CF₄-Gehalt aus einem Gasgemisch von etwa 50-80 Vol.% CF₄ und dem Rest O₂ beim HF-angeregten Plasmaätzen zu bestimmen.

2. Verfahren nach Anspruch 1, dadurch gekennzeichnet,

daß die Gleichmäßigkeit der Ätzung von Leiterplatte zu Leiterplatte in einem Reaktor bestimmt wird, indem man den Wert für die Rückätzung in der Lochmitte $E_{HM}$ an der Stelle E der am langsamsten ätzenden Zelle des Reaktors durch den Mittelwert für die Rückätzung in den Locheingängen $A_{HE}$ an der Stelle A der am schnellsten ätzenden Zelle des Reaktors dividiert.

3. Verfahren nach den Ansprüchen 1 oder 2, dadurch gekennzeichnet, daß bei Bohrungen in einer Leiterplatte mit hohem Verhältnis von Bohrlochdurchmesser zu Leiterplattendicke die gewünschte Ätzfront durch die Wahl des CF₄-Gehalts in O₂ während des Plasmaätzens eingestellt wird.

4. Verfahren nach den Ansprüchen 1 oder 2, dadurch gekennzeichnet, daß das Gasgemisch aus etwa 55 bis 70 Vol.% CF₄ und 45 bis 30 Vol.% Sauerstoff besteht und daß bei einem Gesamtgasfluß von etwa 1,2 l/Min. ein Druck zwischen etwa 0,1 und 1 mbar eingestellt wird.

5. Verfahren nach Anspruch 4, dadurch gekennzeichnet, daß das Gasgemisch aus etwa 60 Vol.% CF₄ und 40 Vol.% Sauerstoff besteht und daß bei einem Gesamtgasfluß von 1,2 l/Min. ein Druck von 0,333 mbar eingestellt wird.

6. Verfahren nach einem oder mehreren der Ansprüche 1 bis 4, dadurch gekennzeichnet, daß der Plasmareaktor nach dem Beladen mit den zu reinigenden Leiterplatten auf einen ersten Druck von etwa 0,066 mbar evakuiert wird;

daß ein Gasgemisch aus etwa 55 bis 70 Vol.% CF₄ und 45 bis 30 Vol.% O₂ zugeführt wird, bis ein zweiter Druck von etwa 0,1 bis 1 mbar erreicht ist;

daß durch Einschalten eines an den Plasmareaktor angeschlossenen Hochfrequenzgenerators ein Plasma erzeugt und zur Entfernung der Verschmierungen aus den Bohrlöchern das Plasma für etwa 60 Minuten aufrechterhalten wird und der Plasmareaktor nach dem Abschalten des Hochfrequenzgenerators und Zuführen von Luft entladen wird.

7. Verfahren nach den Ansprüchen 5 oder 6, dadurch gekennzeichnet, daß die Ausgangsleistung des Hochfrequenzgenerators zwischen etwa 3 und 6 kW, vorzugsweise bei etwa 3,5 kW liegt.

8. Verfahren nach Anspruch 6, dadurch gekennzeichnet, dass die Plasmabehandlung etwa 25 Minuten lang und nach einer etwa 10 Minuten dauernden Unterbrechung weitere 25 Minuten lang durchgeführt wird.

9. Verfahren nach einem oder mehreren der Ansprüche 1 bis 8, dadurch gekennzeichnet, daß die Temperatur während der Plasmabehandlung auf einem Wert zwischen etwa 74 und 121 °C gehalten wird.

10. Verfahren nach den Ansprüchen 1 und 2, dadurch gekennzeichnet, daß die Leiterplatte Abmessungen von etwa 600 x 700 mm und Bohrlöcher mit einem Verhältnis von Bohrlochdurchmesser zu Leiterplattendicke von etwa 1:11 bis 1:13 aufweist.

## Claims

1. Method of removing polymer residues from holes in a circuit board with a high ratio of hole diameter to board thickness, using a CF₄/O₂ plasma,

characterized in that

backetching of polymer residues at the hole entries $A_{HE}$ is determined at the highest etch point A in the outer regions of a circuit board and backetching of the circuit board is determined in the hole center

9

$E_{HM}$ at the lowest etch point E in the center of the same circuit board;

a mean value is determined from the values $A_{HE}$ formed at the two hole entries at point A;

the uniformity of etching is determined across the circuit board by dividing the value for backetching in the hole center $E_{HM}$ at point E by the mean value for backetching at the hole entries $A_{\overline{HE}}$ at point A, using the quotient thus obtained for determining the $CF_4$ content of a gas mixture of about 50 - 80 Vol.% $CF_4$ and the $O_2$ residue optimal for the etch uniformity during HF-energized plasma etching.

2. Method as claimed in claim 1, characterized in that

the uniformity of etching is determined board-by-board in a reactor by dividing the value for backetching in the hole center $E_{HM}$ at point E of the slowest etch cell of the reactor by the mean value for backetching at the hole entries $A_{\overline{HE}}$ at point A of the fastest etch cell of the reactor.

3. Method as claimed in claim 1 or 2, characterized in that for holes in a circuit board with a high ratio of hole diameter to board thickness, the desired etch front is adjusted by the choice of $CF_4$ content in $O_2$ during plasma etching.

4. Method as claimed in claim 1 or 2, characterized in that the gas mixture consists of about 55 to 70 Vol.% $CF_4$ and 45 to 30 Vol.% oxygen, and that a total gas flow of about 1.2 l/min. yields a pressure of between about 0.1 and 1 mbar.

5. Method as claimed in claim 4, characterized in that the mixture consists of about 60 Vol.% $CF_4$ and 40 Vol.% oxygen, and that a total gas flow of 1.2 l/min. yields a pressure of 0.333 mbar.

6. Method as claimed in any one or a combination of claims 1 to 4, characterized in that the plasma reactor, after having been loaded with the circuit boards to be cleaned, is evacuated to a first pressure of about 0.066 mbar;

that a gas mixture of about 55 to 70 Vol.% $CF_4$ and 45 to 30 Vol.% $O_2$ is introduced until a second pressure of about 0.1 to 1 mbar has been reached;

that by switching on a high-frequency generator connected to the plasma reactor, a plasma is generated and maintained for about 60 minutes for desmearing the holes, and the plasma reactor is discharged by the introduction of air after the high-frequency generator has been switched off.

7. Method as claimed in claim 5 or 6, characterized in that the output capacity of the high-frequency generator is between about 3 and 6 kW, preferably about 3.5 kW.

8. Method as claimed in claim 6, characterized in that the plasma treatment is carried out for about 25 minutes and after an interruption of about 10 minutes for another 25 minutes.

9. Method as claimed in any one or a combination of claims 1 to 8, characterized in that the temperature during plasma treatment is kept at a value of between about 74 and 121° C.

10. Method as claimed in claims 1 and 2, characterized in that the circuit board has dimensions of about 600 x 700 mm and holes at a ratio of hole diameter to circuit board thickness of about 1:11 to 1:13.

**Revendications**

1. Procédé pour éliminer des résidus de polymère dans des trous d'une plaquette à circuit imprimé, ayant une importante capacité de perçage par rapport à l'épaisseur de la plaquette à circuit imprimé, au moyen d'un plasma de $CF_4/O_2$, caractérisé en ce que le décapage en retrait de résidus de polymère dans les entrées de trous $A_{HE}$ est déterminé au point A, se décapant le plus, dans les zones extérieures d'une plaquette à circuit imprimé, et le décapage en retrait des mêmes résidus au milieu du trou $E_{HM}$ est déterminé au point E, se décapant le moins, au milieu de la même plaquette à circuit imprimé ;

la valeur moyenne est formée des valeurs $A_{HE}$ mesurées au point A dans les deux entrées de trous ;

l'uniformité du décapage sur la plaquette à circuit imprimé est déterminée en ce qu'on divise la valeur du décapage en retrait dans le milieu du trou $E_{HM}$ au point E par la valeur moyenne du décapage en retrait dans les entrées de trous $A_{HE}$ au point A, et le quotient ainsi obtenu sert à définir la teneur optimale en $CF_4$, pour l'uniformité du décapage, dans un mélange gazeux, composé d'environ 50-80 % en volume de $CF_4$ et le reste en $O_2$, pour un décapage au plasma stimulé par H.F.

2. Procédé selon la revendication 1, caractérisé en ce que l'uniformité du décapage d'une plaquette à circuit imprimé par rapport à une autre plaquette à circuit imprimé est déterminée dans un réacteur en ce qu'on divise la valeur du décapage en retrait au milieu du trou $E_{HM}$ au point E de l'élément du réacteur se décapant le plus lentement par la valeur moyenne du décapage en retrait dans les entrées de trous $A_{HE}$ au point A de l'élément du réacteur se décapant le plus rapidement.

3. Procédé selon la revendication 1 ou 2, caractérisé en ce que, dans des perçages réalisés dans une plaquette à circuit imprimé ayant une grande proportion de capacité de perçage par rapport à l'épaisseur de la plaquette à circuit imprimé, le front de décapage souhaité est réglé par le choix de la teneur en $CF_4$ dans du $O_2$ pendant le décapage au plasma.

4. Procédé selon la revendication 1 ou 2, caractérisé en ce que le mélange gazeux est composé d'environ 55 à 70 % en volume de $CF_4$ et 45 à 30 % en volume d'oxygène et qu'avec un flux gazeux total d'environ 1,2 l/minute, la pression est réglée entre environ 0,1 et 1 mb.

5. Procédé selon la revendication 4, caractérisé en ce que le mélange gazeux est composé d'environ 60 % en volume de $CF_4$ et 40 % en volume d'oxygène et qu'avec un flux gazeux total de 1,2 l/minute, la pression est réglée à 0,333 mb.

6. Procédé selon l'une ou plusieurs des revendications 1 à 4, caractérisé en ce qu'après avoir placé les plaquettes à circuit imprimé à nettoyer dans le réacteur au plasma, on fait le vide dans celui-ci en l'amenant à une première pression d'environ 0,066 mb,

on introduit un mélange gazeux composé d'environ 55 à 70 % en volume de $CF_4$ et 45 à 30 % en volume de $O_2$, jusqu'à ce qu'on obtienne une deuxième pression, d'environ 0,1 à 1 mb,

un plasma est produit par la mise en circuit d'un générateur à haute fréquence connecté au réacteur à plasma, et, pour éliminer les salissures des perçages, on maintient le plasma pendant environ 60 minutes, et le réacteur au plasma est déchargé après la mise hors circuit du générateur à haute fréquence et introduction d'air.

7. Procédé selon la revendication 5 ou 6, caractérisé en ce que la puissance de départ du générateur à haute fréquence est comprise entre 3 et 6 kW, et elle est de préférence d'environ 3,5 kW.

8. Procédé selon la revendication 6, caractérisé en ce que le traitement au plasma est réalisé pendant environ 25 minutes et, après une interruption d'environ 10 minutes, on le prolonge pendant 25 minutes.

9. Procédé selon l'une ou plusieurs des revendications 1 à 8, caractérisé en ce qu'on maintient la température à une valeur d'environ 74 à 121 ° C pendant le traitement au plasma.

10. Procédé selon les revendications 1 et 2, caractérisé en ce que la plaquette à circuit imprimé présente des dimensions d'environ 600 x 700 mm et des trous selon une proportion de capacité de perçage par rapport à l'épaisseur de la plaquette à circuit imprimé d'environ 1:11 à 1:13.

FIG. 1

FIG. 2

FIG. 3A

FIG. 3C

FIG. 3B

FIG. 3D

FIG. 3E

EP 0 208 012 B1

FIG.4

FIG.5

FIG. 6